# EUROPEAN PATENT SPECIFICATION

(11) **EP 2 327 551 B1**
(45) Date of publication and mention of the grant of the patent: **21.10.2015**
(21) Application number: 10010214.4
(22) Date of filing: 22.09.2010
(51) Int. Cl.: B41J 2/14

(54) **Piezoelectric actuator, liquid discharge head and method of manufacturing same**
Piezoelektrischer Aktor, Flüssigkeitabgabekopf und Verfahren zu dessen Herstellung
Actionneur piézoélectrique, tête de décharge liquide et son procédé de fabrication

(30) Priority: 30.11.2009 JP 2009271391
(43) Date of publication of application: 01.06.2011
(73) Proprietor: BROTHER KOGYO KABUSHIKI KAISHA, Aichi-ken 467-8561 (JP)
(72) Inventor: Kobayashi, Yasunori, Nagoya-shi Aichi 467-8562 (JP)
(74) Representative: Kuhnen & Wacker

(56) References cited:
- US-A1- 2003 112 298
- US-A1- 2004 125 177
- US-A1- 2005 168 537
- US-A1- 2009 002 462

## Description

### BACKGROUND OF THE INVENTION

### 1. Technical Field

The present invention relates to a piezoelectric actuator a liquid discharge head provided the same, and methods of manufacturing the piezoelectric actuator and the liquid discharge head.

### 2. Description of the Related Art

A known liquid discharge head configured to discharge liquid from a plurality of discharge ports include piezoelectric actuators configured to apply discharging energy to the liquid in pressure chambers, which communicate with the discharge ports, respectively (for example, see JP-A-2009-078564). The piezoelectric actuators each include a piezoelectric layer such as PZT for example, a common electrode, and a plurality of individual electrodes. The common electrode is disposed to span the pressure chambers, which are in fluid communication with the respective discharge ports, and maintained at a predetermined potential. The individual electrodes are disposed at positions overlappping the plurality of pressure chambers so that the piezoelectric layer is interposed between the common electrode and the individual electrodes. A metal terminal is disposed on each individual electrode, and a wiring member is connected to the metal terminal. When a voltage is applied to the individual electrode via the wiring member, a potential difference is developed between the individual electrode and the common electrode. Consequently, the piezoelectric layer is changed in shape, the capacity of the pressure chamber is changed, and the liquid in the pressure chamber is compressed, so that the liquid is discharged from the discharge port.

The US 2009/0002462 A1 discloses an actuator unit for applying pressure to liquid in each of pressure chambers formed in a passage unit including a piezoelectric layer; a common electrode formed on one surface of the piezoelectric layer to be positioned over the pressure chambers; and electric field blocking layers formed on an opposite surface of the piezoelectric layer from the one surface to be opposed to the common electrode and outside regions of the respective pressure chambers, wherein the electric field blocking layers are made of an oxide film obtained by anodizing aluminum as a base material having a lower dielectric constant than the piezoelectric layer.

The US 2003/0112298 A1 discloses a lattice array-structured piezoelectric actuator comprising a common electrode and a signal electrode separately formed on two major faces of each of tabular piezoelectric actuator elements arrayed on a substrate. On a flexible printed circuit board, formed are electric bonding pads, which are to be electrically connected with the substrate of the actuator elements. A semi-spherical bump including a conductive core and a conductive sealant is formed on each of pads. The actuator elements having substrate is made to face the flexible printed circuit board, and heated under pressure to thereby electrically bond the signal electrodes to the corresponding bumps. Thus bonded, there exists a gap around the core, and it allows the actuator area of the signal electrode to act completely free, not interfered with any other.

However, the piezoelectric actuator as described above may be cracked by a force applied thereto when handling the piezoelectric actuator. If a crack extending from the metal terminal to the common electrode occurs, migration (i.e., a phenomenon in which a metal ion moves from the metal terminal to the common electrode) may occur, which could cause deteriorated insulation. Consequently, the discharge ports may be not able to discharge the liquid.

### SUMMARY OF THE INVENTION

According to one aspect of the invention, a piezoelectric actuator comprises a piezoelectric layer, an electrode layer disposed on a surface of the piezoelectric layer, a metal terminal disposed on the electrode layer and configured as a contact point with respect to an external terminal, and a first and second metal layers as defined in claim 1.

With the configuration described above, even when a crack occurs, the crack is restrained from propagating beyond the first metal layer. Therefore, occurrence of the crack spanning the piezoelectric layer and the metal terminal is restrained. Therefore, even when inexpensive silver-based material is employed for the metal terminal, the probability of occurrence of deteriorated insulation of the piezoelectric actuator in association with migration of an element (specifically metal) which constitutes the metal terminal may be reduced.

According to another aspect of the invention, the metal terminal is contained in the first metal layer when viewed in a direction orthogonal to the surface of the piezoelectric layer. With the configuration described above, the metal terminal cannot come into contact with the piezoelectric layer without the intermediary of the first metal layer, and the occurrence of the crack spanning the piezoelectric layer and the metal terminal can be restrained further reliably.

According to another aspect of the invention, the metal terminal is contained in the electrode layer when viewed in a direction orthogonal to the surface of the piezoelectric layer. With the configuration described above, the occurrence of the crack spanning the piezoelectric layer and the metal terminal can be restrained further reliably with the electrode layer functioning as a shock absorber.

According to another aspect of the invention, the piezoelectric actuator further comprises a second metal layer disposed between the metal terminal and the electrode layer, wherein the metal terminal is contained in the second metal layer and the second metal layer is contained in the first metal layer when viewed in a direction orthogonal to the surface of the piezoelectric layer. With the configuration described above, when the second metal layer is disposed, occurrence of the crack originated from the second metal layer and reaching the piezoelectric layer is restrained with the first metal layer.

According to another aspect of the invention, the first metal layer includes one of Ti, Ni, and Cr. With the configuration described above, the crack propagation restraining effect by the first metal layer is enhanced.

According to another aspect of the invention, the piezoelectric actuator further comprises a plurality of electrode layers including the electrode layer and being disposed on the surface of the piezoelectric layer, a plurality of metal terminals including the metal terminal, and a plurality of first metal layers including the first metal layer, wherein one of the metal terminals and one of the first metal layers are disposed on each of the plurality of electrode layers.

According to another aspect of the invention, the piezoelectric actuator further comprises a common electrode layer, wherein each of the plurality of electrode layers overlaps the common electrode layer.

With the configuration described above, as regards the large sized piezoelectric layer which is subject to occurrence of the crack, the propagation of the crack, if it occurs, beyond the first metal layer is restrained, so that occurrence of the crack spanning the piezoelectric layer and the metal terminal is restrained.

According to another aspect of the invention, a liquid discharge head comprises a flow channel unit comprising a plurality of individual liquid flow channels each including a respective discharge port configured to discharge liquid and a plurality of pressure chambers. The liquid discharge head comprises a piezoelectric actuator disposed on the flow channel unit. The piezoelectric actuator includes a piezoelectric layer. The piezoelectric actuator includes
a plurality of electrode layers disposed on a surface of the piezoelectric layer. The piezoelectric actuator includes a plurality of metal terminals each being disposed on a respective one of the electrode layers and being electrically connected to the respective electrode layer, and each metal terminal being configured as a contact point with respect to an external terminal. The piezoelectric actuator includes a plurality of metal layers, each being disposed between the piezoelectric layer and respective ones of the metal terminals and the electrode layers. The piezoelectric actuator includes a common electrode layer, wherein each of the plurality of electrode layers overlaps the common electrode layer.

With the configuration described above, even when the crack occurs, the crack is restrained from propagating beyond the metal layer. Therefore, occurrence of the crack spanning the piezoelectric layer and the metal terminal is restrained. Therefore, even when inexpensive silver-based material is employed for the metal terminal, the probability of occurrence of deteriorated insulation of the piezoelectric actuator in association with migration of the element (specifically metal) which constitutes the metal terminal may be reduced.

According to another aspect of the invention, the plurality of metal layers do not oppose the plurality of pressure chambers. With the configuration described above, driving of the piezoelectric layer in association with the liquid discharge is rarely affected by the metal layer.

According to another aspect of the invention, a method of manufacturing a piezoelectric actuator comprises the steps of depositing a first metal layer on a surface of a piezoelectric layer, baking an electrode layer on the surface of the first metal layer, and baking a metal terminal on the electrode layer so as to be electrically connected to the electrode layer.

With the configuration described above, even when the crack occurs, the crack is restrained from propagating beyond the first metal layer. Therefore, occurrence of the crack spanning the piezoelectric layer and the metal terminal is restrained. Therefore, even when inexpensive silver-based material is employed for the metal terminal, the probability of occurrence of deteriorated insulation of the piezoelectric actuator in association with migration of the element (specifically metal) which constitutes the metal terminal may be reduced.

According to another aspect of the invention, the baking of the metal terminal includes baking the metal terminal to be contained in the first metal layer when viewed in the direction orthogonal to the surface of the piezoelectric layer. According to the method of manufacturing the piezoelectric actuator as described above, the metal terminal cannot come into contact with the piezoelectric layer without the intermediary of the first metal layer, and the occurrence of the crack spanning the piezoelectric layer and the metal terminal can be restrained further reliably.

According to another aspect of the invention, the baking of the metal terminal includes baking the metal terminal to be contained in the electrode layer when viewed in the direction orthogonal to the surface of the piezoelectric layer. According to the method of manufacturing the piezoelectric actuator as described above, the occurrence of the crack spanning the piezoelectric layer and the metal terminal can be restrained further reliably with the electrode layer functioning as the shock absorber.

According to another aspect of the invention, the method of manufacturing the piezoelectric actuator further comprises a step of baking a second metal layer on the electrode layer, wherein the step of baking the metal terminal on the electrode layer includes baking the metal terminal on the second metal layer, and wherein the baking of the metal terminal includes baking the metal terminal to be contained in the second metal layer, and the baking of the second metal layer includes baking the second metal layer to be contained in the first metal layer when viewed in the direction orthogonal to the surface of the piezoelectric layer. According to the method of manufacturing the piezoelectric actuator as described above, when the second metal layer is formed, occurrence of the crack originated from the second metal layer and reaching the piezoelectric layer can be restrained further reliably with the first metal layer.

According to another aspect of the invention, a method of manufacturing a liquid discharge head comprising a flow channel unit comprises a step of forming a piezoelectric actuator including depositing a metal layer on a surface of a piezoelectric layer, baking an electrode layer on the surface of the metal layer, and baking a metal terminal on the electrode layer. The method of manufacturing a liquid discharge head comprises a step of laminating the piezoelectric actuator on a surface of a flow channel unit so that the electrode layer overlaps a pressure chamber and the metal terminal overlaps a portion of the flow channel unit other than the pressure chamber.

With the method of manufacturing the liquid discharge head as described above, even when the crack occurs, the crack is restrained from propagating beyond the first metal layer. Therefore, occurrence of the crack spanning the piezoelectric layer and the metal terminal is restrained. Therefore, even when inexpensive silver-based material is employed for the metal terminal, the probability of occurrence of deteriorated insulation of the piezoelectric actuator in association with migration of the element (specifically metal) which constitutes the metal terminal may be reduced.

### BRIEF DESCRIPTION OF THE DRAWINGS

Fig. 1 is a schematic side view showing a general configuration of an ink-jet printer according to an embodiment of the invention.
Fig. 2 is a cross-sectional view taken along the widthwise direction of an ink-jet head shown in Fig. 1.
Fig. 3 is a plan view of a head body shown in Fig. 1.
Fig. 4 is an enlarged view of an area surrounded by a long and short dash line shown in Fig. 2.
Fig. 5 is a cross-sectional view taken along the line V-V in Fig. 4.
Fig. 6A is an enlarged view of the area surrounded by the long and short dash line shown in Fig. 5.
Fig. 6B is a plan view showing an individual electrode according to an embodiment.
Fig. 7A is a cross-sectional view showing a step of forming a metal layer shown in Fig. 6A in a method of manufacturing the head body according to an embodiment.
Fig. 7B is a cross-sectional view showing a step of forming the individual electrode shown in Fig. 6A in the method of manufacturing the head body according to the embodiment.
Fig. 7C is a cross-sectional view showing a step of forming a land shown in Fig. 6A in the method of manufacturing the head body according to the embodiment.
Fig. 7D is a cross-sectional view showing a step of forming a bump shown in Fig. 6A in the method of manufacturing the head body according to the embodiment.
Fig. 7E is a cross-sectional view showing a step of fixing an actuator unit to a flow channel unit shown in Fig. 6A in the method of manufacturing the head body according to the embodiment.
Fig. 8A is a plan view showing a state in which the metal layer shown in Fig. 6B is disposed in a method of manufacturing the actuator unit according to an embodiment.
Fig. 8B is a plan view showing a state in which the individual electrode in Fig. 6B is disposed in the method of manufacturing the actuator unit according to the embodiment.
Fig. 8C is a plan view showing a state in which the land is disposed in the method of manufacturing the actuator unit according to the embodiment.
Fig. 8D is a plan view showing a state in which the bump is disposed in the method of manufacturing the actuator unit according to the embodiment.

### DESCRIPTION OF THE EMBODIMENTS

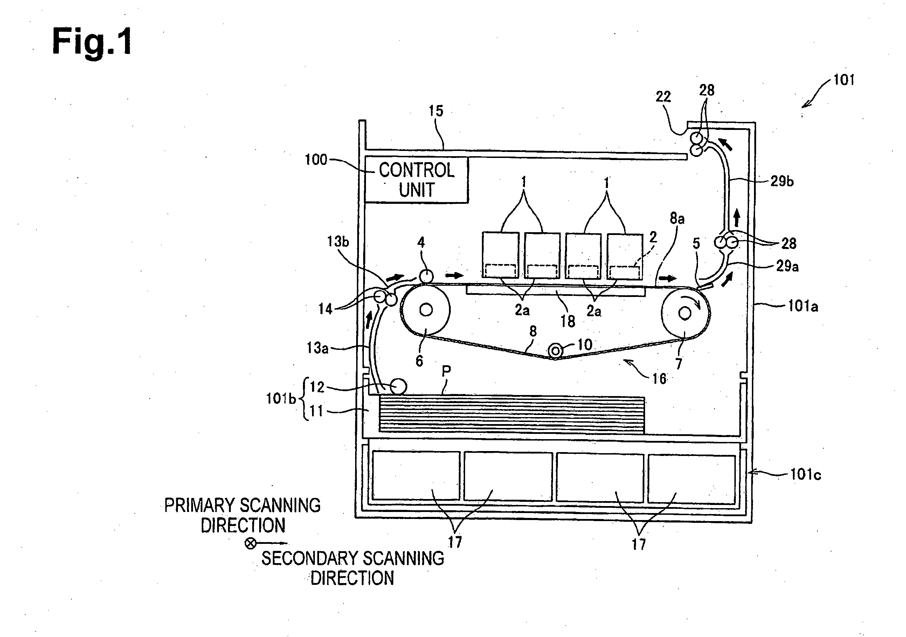

Various embodiments and their features and advantages may be understood by referring to Figs. 1-8, like numerals being used for corresponding parts in the various drawings.

Referring to Fig. 1, an ink-jet head 1 according to an embodiment is disposed in an ink-jet printer 101. The ink-jet printer 101 includes a housing 101a of a parallelepiped shape. In the housing 101a, four ink-jet heads 1 configured to discharge ink downward from above, a transporting device 16 configured to transport a paper P, a paper feed unit 101b configured to feed the paper P, and a tank unit 101c configured to store the ink therein are disposed. A control unit 100 configured to control operations of the respective devices is disposed at a position to avoid interference with the devices. A paper output portion 15 is disposed on an upper portion of a top plate of the housing 101a, so that the paper P is discharged on the paper output portion 15.

The four ink-jet heads 1 each are formed into a substantially parallelepiped shape elongated in a primary scanning direction, and are arranged and secured along the transport direction (i.e., secondary scanning direction) of the paper P. In other words, the printer 101 is a line-type printer, and the transport direction and the primary scanning direction have a relation orthogonal to each other.

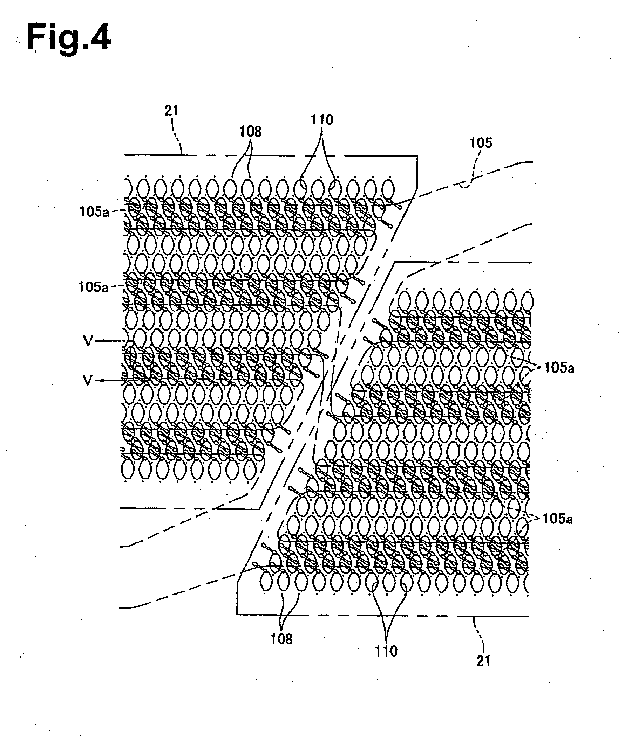

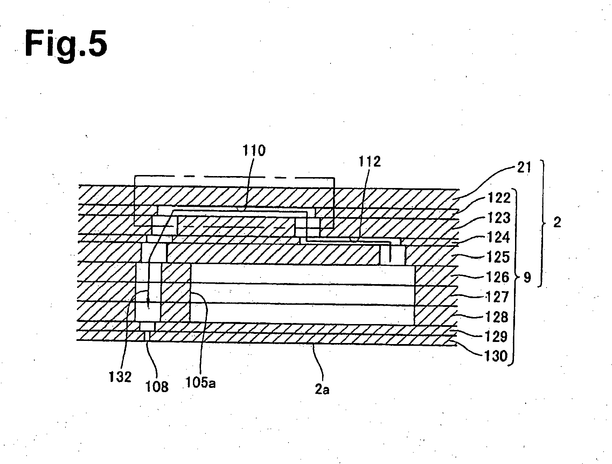

The each ink-jet head 1 includes a head body 2 formed with a plurality of discharge ports 108 (see Fig. 4 and Fig. 5). Each discharge port 108 is opened at a discharge surface 2a, which is a lower surface of the head body 2. The discharge surface 2a opposes the transported paper P at a predetermined distance. The ink is discharged from the respective discharge ports 108 under the control of the control unit 100, whereby an image is formed on the upper surface of the paper P.

The transporting device 16 includes two belt rollers 6 and 7, a transporting belt 8, a tension roller 10, and a platen 18. The transporting belt 8 is an endless belt wound around the both rollers 6 and 7 so as to extend therebetween, and a tension is applied thereto by the tension roller 10. The platen 18 is arranged in an area inside the transporting belt 8, and supports the transporting belt 8 at a position opposing the ink-jet heads 1 at a distance suitable for image formation. The belt roller 7 is a driving roller driven and rotated clockwise in Fig. 1 by a motor, not shown, and to cause the transporting belt 8 to travel. The belt roller 6 is a driven roller rotated by the transporting belt 8 being travelled. Accordingly, the transporting device 16 is capable of transporting the paper P placed on the transporting belt 8 in the transport direction (i.e., from the left to the right (the direction of transport) in Fig. 1).

The paper feed unit 101b is disposed to be mounted on and removed from the housing 101a. The paper feed unit 101b may include a paper feed tray 11 and a paper feed roller 12. The paper feed tray 11 have a box shape opening upward, and may store the plurality of pieces of paper P in a stacked state. The paper feed roller 12 feeds the uppermost piece of paper P on the paper feed tray 11 under the control of the control unit 100. The fed paper P is guided by guides 13a and 13b and fed to the transporting device 16 by a feed roller pair 14.

The tank unit 101c includes four ink tanks 17 stored in the interior thereof. The ink tanks 17 are removably mounted on the tank unit 101c. The respective ink tanks 17 include ink in colors different from each other (e.g., cyan, magenta, yellow, and black). The ink in each ink tank is supplied to the corresponding ink-jet head 1 via an ink tube (not shown).

A transporting route is formed in the interior of the ink-jet printer 101 (along black arrows shown in Fig. 1). The route has generally an S-shape inverted in the lateral direction. When the paper P fed from the paper feed unit 101b positioned below the transporting route passes in front of the discharge surfaces 2a, the inks are discharged from the four ink-jet heads 1 in sequence under the control of the control unit 100, whereby a desired color image is formed on the upper surface of the paper P. The paper P formed with the image is fed from the transporting device 16. The paper P is fed by a feed roller pair 28 along guides 29a and 29b, and ejected from an output port 22 formed on the upper portion of the housing 101a onto the paper output portion 15.

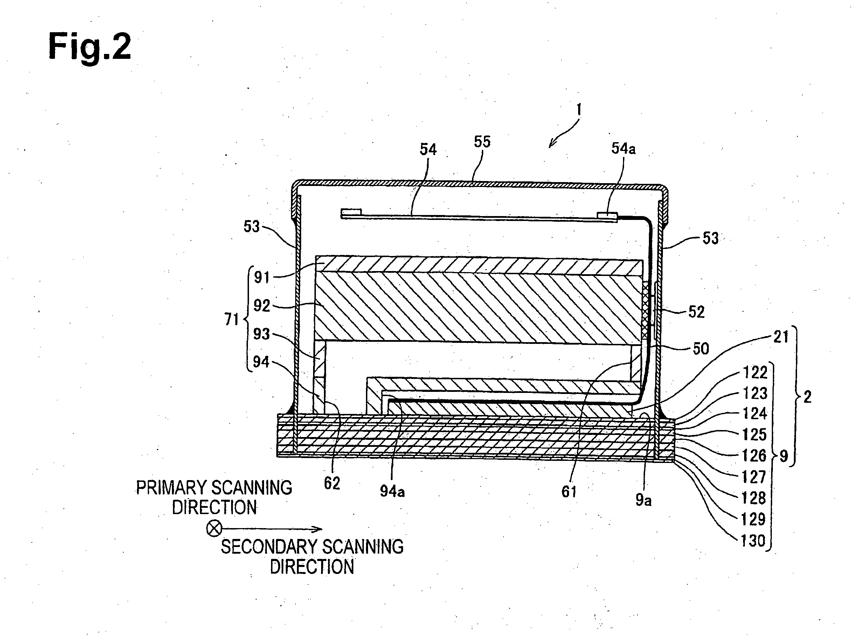

Referring to Fig. 2, the four ink-jet heads 1 have the same configuration. The ink-jet head 1 has a laminated structure including the head body 2 including a flow channel unit 9 and the actuator unit 21, a reservoir unit 71 configured to supply the ink to the head body 2, and a control board 54 having electronic components mounted thereon. The control board 54 and the actuator unit 21 are electrically connected by a flat flexible substrate (i.e., COF (Chip On Film)) 50. A side cover 53 and a head cover 55 are disposed on the flow channel unit 9. The actuator units 21, the reservoir unit 71, the COFs 50, and the control board 54 are positioned in a space defined by the upper surface of the flow channel unit 9, the side cover 53 and the head cover 55, and ink mist is prevented from entering therein from the outside.

The reservoir unit 71 is a flow channel member including four plates 91 to 94 laminated therein. The ink to be supplied to the flow channel unit 9 is temporarily stored in the reservoir unit 71. An ink reservoir 61 to which the ink is supplied from the outside, and ten ink outflow channels 62, which are branched from the ink reservoir 61, are disposed in the interior of the reservoir unit 71. In Fig. 2, only one of the ink outflow channels 62 is shown. The plate 93 may include the ink reservoir 61 as an ink trap. The plate 94 include ten protrusions 94a which are disposed on the lower surface thereof. The ink outflow channel 62 opens at a position which is positioned at the distal end surface of the protrusions 94a. The distal end surfaces of the protrusions 94a are joined to an upper surface 9a of the flow channel unit 9, so that the ink flow channels of the reservoir unit 71 and the flow channel unit 9 are communicated with each other. Depressed portions defined by the protrusions 94a on the lower surface of the plate 94 form a clearance between the plate 94 and the flow channel unit 9, and four actuator units 21 are arranged in the clearance.

The COF 50 is connected at one end thereof to the upper surface of the actuator unit 21, and at the other end thereof to a connector 54a on the control board 54. A driver IC 52 is mounted on a midsection of the COF 50. The driver IC 52 is in contact with an inner wall surface of the side cover 53. The side cover 53 is a metal plate member, and functions as a heat-discharging plate with respect to the driver IC 52.

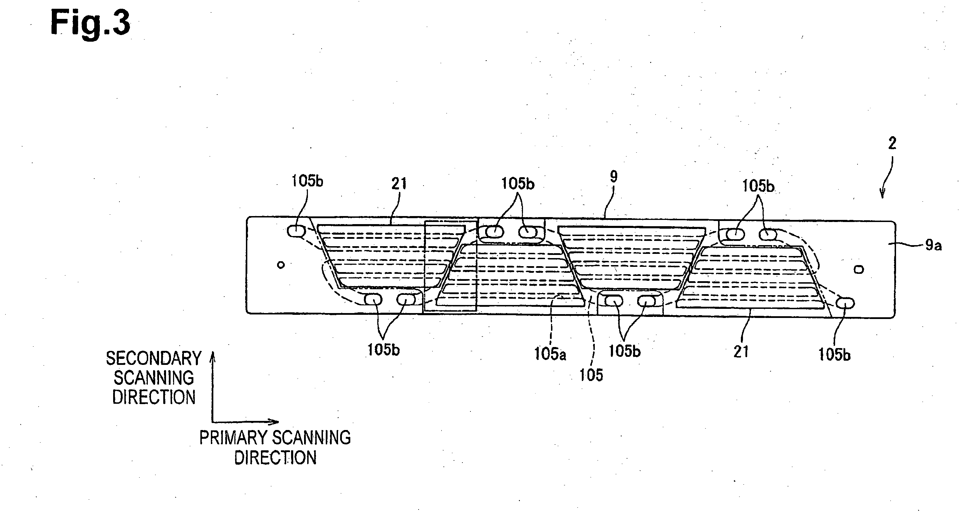

Referring to Fig. 3, the head body 2 includes the flow channel unit 9, and the four actuator units 21 which are positioned on the upper surface 9a of the flow channel unit 9.

The flow channel unit 9 is a flow channel member including nine laminated plates 122 to 130. The flow channel unit 9 has substantially the same size and shape as the plate 94 of the reservoir unit 71. The plates 122 to 130 each are elongated in the primary scanning direction and have a rectangular shape in plan view. Ink flow channels extending from ink supply ports 105b on the upper surface 9a to the discharge ports 108 of the lower surface (i.e., discharge surface 2a) are formed in the interior of the laminated member. The ink flow channels each include, as shown in Fig. 3 to Fig. 5, a manifold flow channel 105 communicated at one end thereof to the ink supply port 105b, sub manifold flow channels 105a branched from the manifold flow channel 105, and a plurality of individual ink flow channels 132 extending from exits of the sub manifold flow channels 105a to the discharge ports 108 via the pressure chamber 110. Referring to Fig. 4, a plurality of pressure chambers 110 are formed to open on the upper surface 9a, in addition to the plurality of ink supply ports 105b. The plurality of pressure chambers 110 are arranged in a matrix pattern. The pressure chambers 110 and the ink supply ports 105b are formed as holes penetrating through the plate 122 and the openings thereof, respectively. The discharge ports 108 of the same number as the pressure chambers 110 are formed to open the discharge surface 2a in a matrix pattern.

The ink supplied from the reservoir unit 71 into the flow channel unit 9 via the ink supply ports 105b is distributed to the sub manifold flow channels 105a from the manifold flow channels 105. The ink in the sub manifold flow channels 105a flows into the individual ink flow channels 132, and reaches the discharge ports 108 via the apertures 112 which function as throttles and the pressure chambers 110.

Referring back to Fig. 3, the four actuator units 21 each have a trapezoidal shape in plan view. The plurality of actuators are arranged in a zigzag pattern in the primary scanning direction so as to avoid the ink supply ports 105b. The parallel opposite sides of the each actuator unit 21 extend along the primary scanning direction, and oblique sides of the adjacent actuator units 21 are overlapped with each other in the transport direction.

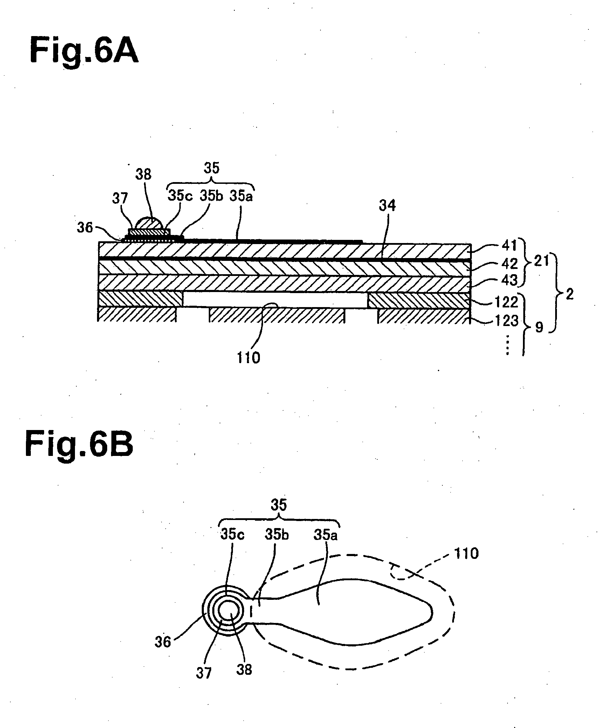

Referring to Fig. 6A, the actuator units 21 include three piezoelectric layers 41 to 43 formed of ceramic material based on lead zirconate titanate (i.e., PZT) having a ferroelectric characteristics. Individual electrodes 35 respectively overlapping the plurality of pressure chambers 110 are disposed on the surface of the uppermost piezoelectric layer 41 as shown in Figs. 6A and 6B. A common electrode 34 which is formed over the entire surface of the sheet is positioned between the piezoelectric layer 41 and the piezoelectric layer 42 on the lower side of the piezoelectric layer 41.

Referring to Fig. 6B, the individual electrode 35 includes a main electrode portion 35a arranged so as to overlap the pressure chambers 110, a connecting portion 35b led from the main electrode portion 35a, and a terminal portion 35c positioned at the distal end of the connecting portion 35b. The main electrode portion 35a has a similar shape to the pressure chambers 110, and has substantially a diamond shape slightly smaller than that in plan view. The connecting portion 35b is led from one of the acute angle portions of the main electrode portion 35a, and the distal end portion thereof does not overlap the pressure chambers 110 as illustrated in Figs. 6A and 6B. The terminal portion 35c has a circular shape in plan view. In this embodiment, the terminal portion 35c does not overlap to the pressure chambers 110 as well.

The individual electrode 35 is disposed by baking conductive paste includes AU as a main ingredient. In addition to Au, metal fine particles of Ag, Ag-Pd can be included as materials of the individual electrode 35. Such materials are used in the form of paste containing these metal fine particles.

Metal layers 36 are disposed between the respective terminal portions 35c and the piezoelectric layer 41. The metal layer 36 is slightly larger than the terminal portion 35c, and has a circular shape in plan view. In this manner, the metal layer 36 and the terminal portion 35c are laminated in sequence on the piezoelectric layer 41. The metal layer 36 does not overlap the pressure chambers 110 as well. The metal layer 36 is formed by Vacuum Vapor Deposition using either one of Ti, Ni, and Cr as a deposition material. The method of forming the metal layer 36 is not limited to Vacuum Vapor Deposition, as other methods such as Physical Vapor Deposition (PVD) or Chemical Vapor Deposition (CVD) may also be used.

A land 37 is disposed on each terminal portion 35c. The land 37 is slightly smaller than the terminal portion 35c, and has a circular shape in plan view. The land 37 is disposed by baking conductive paste formed of Ag-Pd as a main ingredient. In addition to Ag-Pd, the metal fine particles of Ag, Au can be included as a material of the land 37, and is used in the form of paste containing these metal fine particles.

A bump 38 which has a convex shape and is formed of a metal material containing Ag is disposed on each land 37. The bump 38 is slightly smaller than the land 37, and has a circular shape in plan view. The outline is a semispherical shape as shown in Fig. 6A. In this manner, the metal layer 36, the terminal portion 35c, the land 37, and the bump 38 are stacked on the piezoelectric layer 41 substantially coaxially. Referring to Fig. 6B, in plan view, the bump 38 is contained in the land 37, the land 37 is contained in the terminal portion 35c, and the terminal portion 35c is contained in the metal layer 36. The bump 38 is formed by baking conductive paste which includes Ag as a main ingredient. In addition to Ag, the metal particles of Au, and Ag-Pd can be included as the material of the bump 38, and are used in the form of paste containing these metal fine particles.

The bump 38 is a contact point with respect to a terminal of the COF 50. The individual electrode 35 is connected individually with an output terminal of the driver IC 52 via the bump 38. A driving signal is selectively supplied thereto via the wiring of the COF 50. When the driving signal is supplied to the individual electrode 35, portions of the actuator unit 21 corresponding to the individual electrodes 35 can be deformed independently. Portions overlapped with the individual electrodes 35 function as individual actuators. In this manner, the actuator unit 21 is an integral driving element group, and includes actuators of the same number as the pressure chambers 110 integrated therein.

In the actuator unit 21, the uppermost piezoelectric layer 41 is polarized in the direction of thickness. Portions of the piezoelectric layer 41 interposed between the individual electrode 35 and the common electrode 34 is displaced by the application of electric field. The active portions are displaced in at least one vibration mode selected from d₃₁, d₃₃, and d₁₅. In this embodiment, the active portions are displaced in the vibration mode of d₃₁. Portions (non-active portions) of the piezoelectric layers 42 and 43 opposing the individual electrodes 35 do not deform even when the electric field is applied. The each actuator in this combination is a piezoelectric element of a type having so-called a unimorph-structure.

The common electrode 34 is connected to the ground so that a reference potential is equally applied to the areas corresponding to all the pressure chambers 110. When the individual electrode 35 is controlled to a predetermined positive or negative potential and an electric field in the direction of polarization is applied to the active portions, the active portions contract in the direction orthogonal to the direction of polarization (i.e., direction of plane) by a piezoelectric lateral effect. In contrast, the piezoelectric layers 42 and 43 do not spontaneously deform even though the electric field is applied, and hence the difference in distortion in the direction of plane occurs between the upper piezoelectric layer 41 and the lower piezoelectric layers 42 and 43. With this difference in distortion, the entire piezoelectric layers 41 to 43 are ready to deform in a convex shape toward the pressure chamber 110 (i.e., unimorph deformation).

Here, since the piezoelectric layers 41 to 43 are fixed to the upper surface of the cavity plate 122 which sectionalizes the pressure chambers 110, areas (i.e., individual actuators) corresponding to the active portions deform in a convex shape toward the pressure chambers 110 . At this time, the capacities of the pressure chambers 110 are reduced, a pressure (i.e., discharge energy) is applied to the ink in the respective pressure chambers 110, and ink drops are discharged from the discharge ports 108. Subsequently, when the potentials of the individual electrode 35 are returned to the same potential as the common electrode 34, the areas corresponding to the active portions are restored to their original shapes, and the capacities of the pressure chambers 110 return to the original capacities, so that the ink is sucked from the manifold flow channel 105 into the pressure chambers 110.

As another method of driving, a method of controlling the individual electrodes 35 to potentials different from that of the common electrode 34 in advance, bringing the potentials of the individual electrodes 35 into the same potentials as the common electrode 34 once upon receipt of a discharge request, and bringing the potentials of the individual electrodes 35 to the potentials different from that of the common electrode 34 after the elapse of a predetermined time period is also applicable. In this case, in the initial state, the areas corresponding to the active portions are deformed into a convex shape toward the pressure chambers 110. Upon receipt of the discharge request, the areas corresponding to the active portions become a flat shape at the same timing as the potentials of the individual electrodes 35 become the same as that of the common electrode 34, and the capacities of the pressure chambers 110 are increased in comparison with the initial state. At this time, the ink is sucked into the pressure chambers 110 from the manifold flow channel 105. Subsequently, the areas corresponding to the active portions deform into a convex shape toward the pressure chambers 110 at the timing when the potentials of the individual electrodes 35 assume the potentials different from that of the common electrode 34 again. Accordingly, the pressures applied to the ink are increased due to the decrease of the capacities of the pressure chambers 110, so that the ink is discharged.

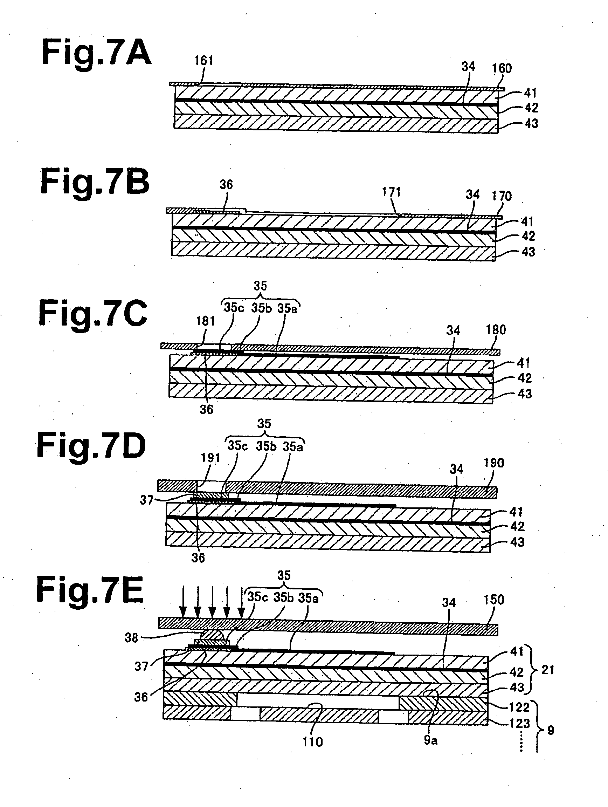

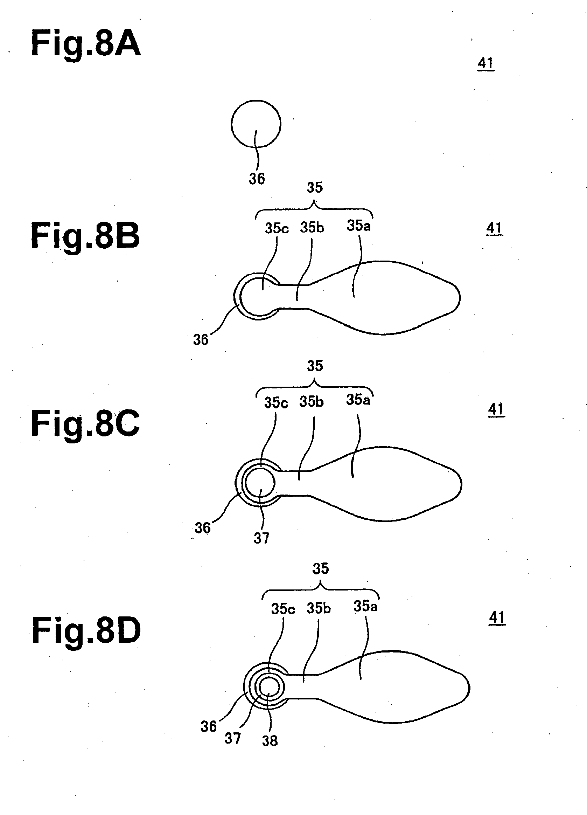

Referring to Fig. 7 and Fig. 8, in order to manufacture the head body 2, the flow channel unit 9 and the actuator units 21 are fabricated separately, and then are assembled with an adhesive agent. In order to manufacture the actuator unit 21, the piezoelectric layers 41 to 43 of the laminated member are formed first. When forming the piezoelectric layers 41 to 43, green sheets having predetermined shape and size using piezoelectric ceramics powder are formed. A plurality of through holes are formed on the green sheet at a peripheral edge portion thereof for fabricating the piezoelectric layer 41. A common electrode pattern is formed on the green sheet by a screen printing process for fabricating the piezoelectric layer 42. The common electrode pattern occupies the substantially entire part of the upper surface of the green sheet. Subsequently, these two green sheets are laminated with the green sheet with the electrode pattern formed thereon placed therebetween, so that a precursor of the piezoelectric layers 41 to 43 including the three green sheets is disposed. On the electrode pattern, the green sheet having the through holes is laminated. The through holes are opened with respect to the common electrode pattern. After having formed the precursor, the conductive paste is filled into the through holes. For example, Ag-Pd based paste is used. Then, the precursor is degreased and baked (e.g., 900 to 1000°C) , so that the piezoelectric layers 41 to 43 are obtained.

Referring to Fig. 7A, a mask 160 is used to form the metal layer 36 by Vacuum Vapor Deposition. More specifically, the metal layer 36 is formed using a publicly known Vacuum Vapor Deposition apparatus. First of all, the baked piezoelectric layers 41 to 43 covered with the mask 160 on the surface of the piezoelectric layer 41 are supported in a vacuum chamber of the apparatus. Pellets of Ti, Ni, or Cr as a deposition source are set so as to oppose the piezoelectric layers 41 to 43. When the vacuum in the vacuum chamber reaches 10⁻³ to 10⁻⁴ Pa, the pellets are evaporated by resistance heating or electron beam heating. The mask 160 is formed with circular openings 161 arranged in a matrix pattern. Since the evaporated particles fly linearly in the vacuum chamber, the metal layers 36 are disposed on the upper surface of the piezoelectric layer 41 in the same circular shape in plan view as the openings 161. Deposited metal films are high in purity and also in flexibility.

Referring to Fig. 7B, an electrode arrangement pattern is formed on the surface of the piezoelectric layer 41 by the screen printing process. A mask 170 for printing includes openings 171 which are formed in a matrix pattern. The openings 171 have a shape corresponding to the individual electrode 35 (i.e., the main electrode portions 35a, the connecting portions 35b, and the terminal portions 35c). Prior to the printing, the mask 170 is registered with the piezoelectric layers 41 to 43 so that the portions of the terminal portion 35c of the mask 170 are contained in the metal layers 36, respectively. The Au based conductive paste is used for the printing. After the printing, baking is performed at a temperature from 500 to 1000°C. Accordingly, the individual electrodes 35 corresponding to the mask pattern are formed as shown in Fig. 8B. The terminal portions 35c of the individual electrodes 35 are contained in the metal layers 36 respectively in plan view, and parts of the connecting portions 35b and the terminal portions 35c are superimposed on the metal layers 36. The main electrode portions 35a and the remaining part of the connecting portions 35b are disposed on the surface of the piezoelectric layer 41. The thickness of the individual electrodes 35 is on the order of 0.1 to 1 µm.

Referring to Fig. 7C, an electrode arrangement pattern is formed on the terminal portion 35c by the screen printing process. A mask 180 for printing includes openings (not shown) corresponding to the lands of the common electrode 34, in addition to circular openings 181 corresponding to the lands 37. The openings 181 are arranged in a matrix pattern. The openings corresponding to the lands of the common electrode 34 are arranged so as to surround the openings 181 for the lands 37 from four sides. The openings corresponding to the lands for the common electrode 34 are elongated along the opposed parallel sides of the trapezoids. Prior to the printing, the mask 180 is registered with the piezoelectric layers 41 to 43 so that the portions of the mask 180 corresponding to the lands 37 are contained in the terminal portions 35c respectively. At this time, the openings corresponding to the lands for the common electrode 34 oppose the through holes (not shown) of the piezoelectric layer 41. Ag-Pd based paste is used for the printing. After the printing, baking is performed at a temperature from 500 to 1000°C. Accordingly, the lands 37 corresponding to the mask pattern are formed as shown in Fig. 8C. The lands 37 are contained in the terminal portions 35c of the individual electrodes 35 respectively in plan view. The lands for the common electrodes 34 are superimposed on the conductive members filled in the through holes of the piezoelectric layer 41, and are electrically connected to the common electrode 34. The thickness of the lands 37 is on the order of 10 µm.

Referring to Fig. 7D, an electrode arrangement pattern is formed on the lands 37 by the screen printing process as shown in Fig. 7D. A mask 190 for printing includes openings corresponding to the bumps of the common electrode in addition to circular openings 191 corresponding to the bumps 38. The openings corresponding to the both bumps are arranged in the same manner as the openings corresponding to the both lands. The size is slightly smaller than the openings of the respective lands. Prior to the printing, the mask 190 is registered with the piezoelectric layers 41 to 43 so that the portions of the mask 190 corresponding to the bumps 38 are contained in the lands 37 respectively. At this time, the openings corresponding to the bumps for the common electrode 34 oppose the through holes of the piezoelectric layer 41. The Ag based conductive paste is used for the printing. After the printing, baking is performed at a temperature from 100 to 200°C. The electrode arrangement pattern is hardened by this baking. Accordingly, the bumps 38 corresponding to the mask pattern are disposed as shown in Fig. 8D. The bumps 38 are contained in the lands 37 respectively in plan view. The height of the bump 38 from the surface of the piezoelectric layer 41 is on the order of 50 µm.

As described above, the actuator unit 21 is completed by disposing the metal layers 36, the individual electrodes 35, the lands 37, and the bumps 38 on the surface of the piezoelectric layer 41. Aside from the actuator units 21, the flow channel unit 9 is configured by laminating the plates 122 to 130 and joining the same with respect to each other. They are joined by using a heat curing adhesive agent. Referring to Fig. 7E, the actuator units 21 is laminated on the upper surface 9a of the flow channel unit 9 via the heat curing adhesive agent (not shown). At this time, the actuator units 21 and the flow channel unit 9 are registered so that the main electrode portions 35a of the respective individual electrodes 35 overlap the pressure chambers 110, and the respective metal layers 36 do not oppose the pressure chambers 110. At this time, the terminal portions 35c, the lands 37, and the bump 38, which are contained in the metal layers 36 respectively in plan view, does not overlap the pressure chambers 110.

Then, by applying a pressure toward the metal layers 36 against the distal ends of the bumps 38 in the convex shape by a jig 150, the actuator units 21 and the flow channel unit 9 are heated while compressing in the direction toward each other. Accordingly, the actuator units 21 are secured to the flow channel unit 9, and the head body 2 is completed.

The reservoir unit 71, the COFs 50, the control board 54, the side cover 53 and the head cover 55 are prepared according to respective manufacturing procedures separately.

The COFs 50 are attached to the head body 2 so as to be joined with the actuator units 21. Joint terminals, which are connected to the respective output terminals of the driver IC 52 are arranged in the joint areas of the COFs 50. The joint is achieved by heating the joint terminals (e.g., on the order of 200°C) while compressing the same to the corresponding bumps 38. The form of the joint portions here may be such that the joint terminals are joined with the bumps 38 by soldering, or peripheries of the joint terminal and the bumps 38, which come into contact with each other, are coated with heat curing adhesive agent. These forms may be combined with each other.

Subsequently, the reservoir unit 71 is joined to the head body 2. At this time, the protrusions 94a disposed on the plate 94 of the reservoir unit 71 are positioned so as to oppose the ink supply ports 105b of the head body 2. The joint of the both members are achieved by the heat curing adhesive agent interposed therebetween.

The control board 54 is disposed above the reservoir unit 71, and the other ends of the COFs 50 are connected to the connectors 54a on the control board 54. The side cover 53 is disposed on the flow channel unit 9. At this time, the side cover 53 is arranged so that the drivers IC come into contact with the inner wall surface thereof. A boundary between the side cover 53 and the flow channel unit 9, and a boundary between the side covers 53 and the side cover 55 are sealed by a potting agent (not labeled) formed of silicon. The ink-jet head 1 is completed with the procedures described above.

As described above, according to the actuator units 21 provided in the ink-jet head 1 in this embodiment, even when a crack occurs, the crack is restrained from propagating beyond the metal layer 36. Therefore, occurrence of the crack spanning the piezoelectric layer 41 and the bump 38 is prevented. Consequently, even when inexpensive silver-based material is employed for the bumps 38, the probability of occurrence of deteriorated insulation of the actuator units 21 in association with migration of the silver element which constitutes the bumps 38 may be reduced.

In the ink-jet head 1 in this embodiment, the bumps 38 are contained in the metal layers 36 respectively in plan view. Therefore, the bumps 38 cannot come into contact with the piezoelectric layer 41 without the intermediary of the metal layers 36, and the occurrence of the crack astride the piezoelectric layer 41 and the bump 38 can be restrained further reliably.

In the ink-jet head 1 in this embodiment, the bumps 38 are contained in the individual electrodes 35 respectively in plan view. Therefore, the occurrence of the crack spanning the piezoelectric layer 41 and the bump 38 is prevented further reliably by the function of the individual electrodes 35 as shock absorbers.

In the ink-jet head 1 in this embodiment, the lands 37 are disposed between the bumps 38 and the individual electrodes 35 by baking, the bumps 38 are contained in the lands 37, and the lands 37 are contained in the metal layers 36, respectively, in plan view. Therefore, the occurrence of the crack originated from the lands 37 and reaching the piezoelectric layer 41 is prevented by the metal layers 36.

In the ink-jet head 1 in this embodiment, the metal layers 36 are formed of any one of Ti, Ni, and Cr. Therefore, the crack propagation restraining effect by the metal layers 36 is enhanced.

In the ink-jet head 1 in this embodiment, the plurality of individual electrodes 35 are disposed on the surface of the piezoelectric layer 41, and the bump 38 and the metal layer 36 are disposed respectively for these plurality of individual electrodes 35. The common electrode 34 is disposed to overlap the plurality of individual electrodes 35 with the intermediary of the piezoelectric layer 41. Therefore, as regards the large sized piezoelectric layer which is subject to occurrence of the crack, the propagation of the crack beyond the metal layer 36 is restrained if it occurs, so that occurrence of the crack spanning the piezoelectric layer 41 and the bump 38 is restrained.

In the ink-jet head 1 in this embodiment, the plurality of metal layers 36 do not overlap the plurality of pressure chambers 110. Therefore, deformation of the portions of the piezoelectric layers 41 to 43 overlapping the pressure chambers 110 when discharging the ink is rarely impaired by the metal layers 36.

Although the description of the embodiments has been given thus far, the invention is not limited to the above described embodiments, and various modifications may be possible.

For example, in the above described embodiments, the metal layers 36 are disposed on the surface of the piezoelectric layer 41, and the parts of the connecting portion 35b and the terminal portions 35c of the individual electrode 35 are superimposed on the metal layers 36. However, a configuration in which the positional relationship between the individual electrodes 35 and the metal layers 36 in the vertical direction is inverted, all the individual electrodes 35 are formed on the surface of the piezoelectric layer 41, and the metal layers 36 are superimposed on the terminal portions 35c of the individual electrodes may be applicable.

In the above described embodiments, the bumps 38 are contained in the individual electrodes 35 and the metal layers 36 respectively in plan view. However, the bumps 38 may not be contained in the individual electrodes 35, but contained in the metal layer 36.

In the above described embodiments, the bumps 38 are contained in the lands 37, respectively, in plan view, and the lands 37 are contained in the metal layers 36 respectively. However, the lands 37 may not have to be formed.

In the above described embodiments, the metal layers 36 include any one of Ti, Ni, and Cr. However, the metal layers 36 may include other metal substance.

In the above described embodiments, the metal layers 36 do not overlap the pressure chambers 110. However, the metal layers 36 may overlap the pressure chambers 110. Also, each metal layer 36 may have the size and shape containing the entire individual electrode 35.

In the above described embodiments, the actuator units 21 include the laminated member including three piezoelectric layers altogether including one active layer. However, the laminated member may include two layers and not include the piezoelectric layer 43. Alternatively, the laminated member may include four or more multiple layers. In this case, there may be a plurality of layers including the active layer.

In the above described embodiments, the example is applied to the ink-jet head 1 configured to discharge the ink from the discharge ports 108. However, the invention may be applied to a liquid discharging head configured to discharge liquid other than the ink. Furthermore, the invention may be applied to the piezoelectric actuator configured to drive driving units of various apparatuses.
While the invention has been described in connection with various structures and embodiments, it will be understood by those skilled in the art that other variations and modifications of the structures and embodiments described above may be made without departing from the scope of the invention. Other structures and embodiments will be apparent to those skilled in the art from a consideration of the specification or practice of the invention disclosed herein. It is intended that the specification and the described examples are illustrative with the true scope of the invention being defined by the following claims.

## Claims

1. A piezoelectric actuator comprising:
a piezoelectric layer (41);
an electrode layer (35) which is disposed on a surface of the piezoelectric layer (41);
a metal terminal (38) which is disposed on the electrode layer (35) and configured as a contact point with respect to an external terminal;
a first metal layer (36) which is conductive and disposed between the piezoelectric layer (41) and the electrode layer (35); and
a second metal layer (37) disposed between the metal terminal (38) and the electrode layer (35);
**characterised in that** the first metal layer (36) and the electrode layer (35) are both in direct contact with the piezoelectric layer (41).

2. The piezoelectric actuator according to claim 1, wherein the metal terminal (38) is contained in the first metal layer (36) when viewed in a direction orthogonal to the surface of the piezoelectric layer (41).

3. The piezoelectric actuator according to claim 1, wherein the metal terminal (38) is contained in the electrode layer (35) when viewed in a direction orthogonal to the surface of the piezoelectric layer (41).

4. The piezoelectric actuator according to claim 1, wherein the metal terminal (38) is contained in the second metal layer (37) and the second mental layer (37) is contained in the first metal layer (36) when viewed in a direction orthogonal to the surface of the piezoelectric layer (41).

5. The piezoelectric actuator according to claim 1, wherein the first metal layer (36) includes one of Ti, Ni, and Cr.

6. The piezoelectric actuator according to claim 1, further comprising:
a plurality of electrode layers including the electrode layer (35), the plurality of electrode layers being disposed on the surface of the piezoelectric layer (41);
a plurality of metal terminals including the metal terminal (38); and
a plurality of first metal layers (36) including the first metal layer;
wherein one of the metal terminals (38) and one of the first metal layers (36) are disposed on each of the plurality of electrode layers (35).

7. The piezoelectric actuator according to claim 6, further comprising a common electrode layer (34), wherein each of the plurality of electrode layers (35) overlaps the common electrode layer (34).

8. A liquid discharge head comprising:
a flow channel unit (9) comprising a plurality of individual liquid flow channels (132) each including a respective discharge port (108) configured to discharge liquid and a plurality of pressure chambers (110); and
a piezoelectric actuator (21) according to claim 7 disposed on the flow channel unit.

9. The liquid discharge head according to claim 8, wherein the plurality of disposed metal layers (36) do not overlap the plurality of pressure chambers (110).

10. A method of manufacturing a piezoelectric actuator according to any of claims 1 to 7 comprising the steps of:
depositing a first metal layer (36) on a surface of a piezoelectric layer (41);
baking an electrode layer (35) on the surface of the first metal layer (36); and
baking a metal terminal (38) on the electrode layer (35) so as to be electrically connected to the electrode layer; and baking a second metal layer (37) on the electrode layer.

11. The method of manufacturing the piezoelectric actuator according to claim 10, wherein the baking of the metal terminal (38) includes baking the metal terminal (38) to be contained in the first metal layer (36) when viewed in the direction orthogonal to the surface of the piezoelectric layer (41).

12. The method of manufacturing the piezoelectric actuator according to claim 11, wherein the baking of the metal terminal (38) includes baking the metal terminal (38) to be contained in the electrode layer (35) when viewed in the direction orthogonal to the surface of the piezoelectric layer (41).

13. The method of manufacturing the piezoelectric actuator according to claim 12,
wherein the step of baking the metal terminal (38) on the electrode layer (35) includes baking the metal terminal (38) on the second metal layer (37),
wherein the baking of the metal terminal (38) includes baking the metal terminal (38) to be contained in the second metal layer when viewed in the direction orthogonal to the surface of the piezoelectric surface, and
wherein the baking of the second metal layer includes baking the second metal layer to be contained in the first metal layer (38) when viewed in the direction orthogonal to the surface of the piezoelectric layer (41).

14. A method of manufacturing a liquid discharge head comprising a flow channel unit comprising the steps of:
forming a piezoelectric actuator (21) according to claim 10; and
laminating the piezoelectric actuator (21) on a surface of a flow channel unit (9), so that the electrode layer (35) overlaps a pressure chamber (110) and the metal terminal (38) overlaps a portion of the flow channel unit (9) other than the pressure chamber (110).

## Patentansprüche

1. Piezoelektrischer Aktor, aufweisend:
eine piezoelektrische Schicht (41);
eine Elektrodenschicht (35), die auf einer Oberfläche der piezoelektrischen Schicht (41) aufgebracht ist;
einen Metallanschluss (38), der auf der Elektrodenschicht (35) aufgebracht ist und als Kontaktpunkt in Bezug auf einen externen Anschluss gestaltet ist;
eine erste Metallschicht (36), die leitend ist und die zwischen der piezoelektrischen Schicht (41) und der Elektrodenschicht (35) aufgebracht ist; und
eine zweite Metallschicht (37), die zwischen dem Metallanschluss (38) und der Elektrodenschicht (35) aufgebracht ist;
**dadurch gekennzeichnet, dass** die erste Metallschicht (36) und die Elektrodenschicht (35) beide in direktem Kontakt mit der piezoelektrischen Schicht (41) stehen.

2. Piezoelektrischer Aktor nach Anspruch 1, wobei der Metallanschluss (38) bei Betrachtung in einer Richtung, die orthogonal ist zur Oberfläche der piezoelektrischen Schicht (41), in der ersten Metallschicht (36) enthalten ist.

3. Piezoelektrischer Aktor nach Anspruch 1, wobei der Metallanschluss (38) bei Betrachtung in einer Richtung, die orthogonal ist zur Oberfläche der piezoelektrischen Schicht (41), in der Elektrodenschicht (35) enthalten ist.

4. Piezoelektrischer Aktor nach Anspruch 1,
wobei der Metallanschluss (38) bei Betrachtung in einer Richtung, die orthogonal ist zur Oberfläche der piezoelektrischen Schicht (41), in der zweiten Metallschicht (37) enthalten ist und die zweite Metallschicht (37) in der ersten Metallschicht (36) enthalten ist.

5. Piezoelektrischer Aktor nach Anspruch 1, wobei die erste Metallschicht (36) Ti, Ni oder Cr beinhaltet.

6. Piezoelektrischer Aktor nach Anspruch 1, ferner aufweisend:
eine Mehrzahl von Elektrodenschichten einschließlich der Elektrodenschicht (35), wobei die Mehrzahl von Elektrodenschichten auf der Oberfläche der piezoelektrischen Schicht (41) aufgebracht ist;
eine Mehrzahl von Metallanschlüssen einschließlich dem Metallanschluss (38); und
eine Mehrzahl von ersten Metallschichten (36) einschließlich der ersten Metallschicht;
wobei jeweils einer der Metallanschlüsse (38) und eine von den ersten Metallschichten (36) auf jeder von der Mehrzahl von Elektrodenschichten (35) aufgebracht sind.

7. Piezoelektrischer Aktor nach Anspruch 6, ferner eine gemeinsame Elektrodenschicht (34) aufweisend, wobei jede von der Mehrzahl von Elektrodenschichten (35) die gemeinsame Elektrodenschicht (34) überlappt.

8. Flüssigkeitsabgabekopf, aufweisend:
eine Strömungskanaleinheit (9), die eine Mehrzahl von einzelnen Flüssigkeitsströmungskanälen (132) mit jeweils einer entsprechende Ausgabeöffnung (108), die dafür ausgelegt ist, Flüssigkeit auszugeben, und eine Mehrzahl von Druckkammern (110) aufweist; und
einen piezoelektrischen Aktor (21) nach Anspruch 7, der an der Strömungskanaleinheit aufgebracht ist.

9. Flüssigkeitsabgabekopf nach Anspruch 8, wobei die Mehrzahl von aufgebrachten Metallschichten (36) die Mehrzahl von Druckkammern (110) nicht überlappt.

10. Verfahren zur Herstellung eines piezoelektrischen Aktors nach einem der Ansprüche 1 bis 7, die folgenden Schritte beinhaltend:
Abscheiden einer ersten Metallschicht (36) auf einer Oberfläche einer piezoelektrischen Schicht (41);
Einbrennen einer Elektrodenschicht (35) auf der Oberfläche der ersten Metallschicht (36); und
Einbrennen eines Metallanschlusses (38) auf der Elektrodenschicht (35) auf solche Weise, dass sie elektrisch mit der Elektrodenschicht verbunden ist; und Einbrennen einer zweiten Metallschicht (37) auf der Elektrodenschicht.

11. Verfahren zur Herstellung des piezoelektrischen Aktors nach Anspruch 10, wobei das Einbrennen des Metallanschlusses (38) das Einbrennen des Metallanschlusses (38) auf solche Weise beinhaltet, dass er bei Betrachtung in einer Richtung, die orthogonal ist zur Oberfläche der piezoelektrischen Schicht (41), in der ersten Metallschicht (36) enthalten ist.

12. Verfahren zur Herstellung des piezoelektrischen Aktors nach Anspruch 11, (wobei das Einbrennen des Metallanschlusses (38) das Einbrennen des Metallanschlusses (38) auf solche Weise beinhaltet, dass er bei Betrachtung in einer Richtung, die orthogonal ist zur Oberfläche der piezoelektrischen Schicht (41), in der Elektrodenschicht (35) enthalten ist.

13. Verfahren zur Herstellung des piezoelektrischen Aktors nach Anspruch 12,
wobei der Schritt des Einbrennens des Metallanschlusses (38) auf der Elektrodenschicht (35) das Einbrennen der Metallanschlusses (38) auf der zweiten Metallschicht (37) beinhaltet,
wobei das Einbrennen des Metallanschlusses (38) das Einbrennen des Metallanschlusses (38) auf solche Weise beinhaltet, dass er bei Betrachtung in einer Richtung, die orthogonal ist zur piezoelektrischen Oberfläche, in der zweiten Metallschicht enthalten ist, und
wobei das Einbrennen der zweiten Metallschicht das Einbrennen der zweiten Metallschicht auf solche Weise beinhaltet, dass sie bei Betrachtung in einer Richtung, die orthogonal ist zur Oberfläche der piezoelektrischen Schicht (41), in der ersten Metallschicht (38) enthalten ist.

14. Verfahren zur Herstellung eines Flüssigkeitsabgabekopfes, der eine Strömungskanaleinheit aufweist, die folgenden Schritte umfassend:
Ausbilden eines piezoelektrischen Aktors (21) nach Anspruch 10; und
Laminieren des piezoelektrischen Aktors (21) auf eine Oberfläche einer Strömungskanaleinheit (9) auf solche Weise, dass die Elektrodenschicht (35) eine Druckkammer (110) überlappt und der Metallanschluss (38) einen Abschnitt der Strömungskanaleinheit (9) überlappt, bei dem es sich nicht um die Druckkammer (110) handelt.

## Revendications

1. Actionneur piézoélectrique comprenant :
une couche piézoélectrique (41) ;
une couche d'électrode (35) qui est disposée sur une surface de la couche piézoélectrique (41) ;
une borne métallique (38) qui est disposée sur la couche d'électrode (35) et configurée comme un point de contact par rapport à une borne externe ;
une première couche métallique (36) qui est conductrice et disposée entre la couche piézoélectrique (41) et la couche d'électrode (35) ; et
une seconde couche métallique (37) disposée entre la borne métallique (38) et la couche d'électrode (35) ;
**caractérisé en ce que** la première couche métallique (36) et la couche d'électrode (35) sont toutes les deux en contact direct avec la couche piézoélectrique (41).

2. Actionneur piézoélectrique selon la revendication 1, dans lequel la borne métallique (38) est contenue dans la première couche métallique (36) lorsqu'elle est vue suivant une direction orthogonale à la surface de la couche piézoélectrique (41).

3. Actionneur piézoélectrique selon la revendication 1, dans lequel la borne métallique (38) est contenue dans la couche d'électrode (35) lorsqu'elle est vue suivant une direction orthogonale à la surface de la couche piézoélectrique (41).

4. Actionneur piézoélectrique selon la revendication 1, dans lequel la borne métallique (38) est contenue dans la seconde couche métallique (37) et la seconde couche métallique (37) est contenue dans la première couche métallique (36) lorsqu'elle est vue suivant une direction orthogonale à la surface de la couche piézoélectrique (41).

5. Actionneur piézoélectrique selon la revendication 1, dans lequel la première couche métallique (36) comporte un élément parmi Ti, Ni, et Cr.

6. Actionneur piézoélectrique selon la revendication 1, comprenant en outre :
une pluralité de couches d'électrode comportant la couche d'électrode (35), la pluralité de couches d'électrode étant disposée sur la surface de la couche piézoélectrique (41) ;
une pluralité de bornes métalliques comportant la borne métallique (38) ; et
une pluralité de premières couches métalliques (36) comportant la première couche métallique;
dans lequel une des bornes métalliques (38) et une des premières couches métalliques (36) sont disposées sur chacune des couches de la pluralité de couches d'électrode (35).

7. Actionneur piézoélectrique selon la revendication 6, comprenant en outre une couche d'électrode commune (34), dans lequel chacune de la pluralité de couches d'électrode (35) recouvre la couche d'électrode commune (34).

8. Tête de distribution de liquide comprenant :
une unité formant canal d'écoulement (9) comprenant une pluralité de canaux d'écoulement de liquide individuels (132), chacun comportant un orifice de distribution respectif (108) configuré de manière à distribuer du liquide et une pluralité de chambres de pression (110) ; et
un actionneur piézoélectrique (21) selon la revendication 7 agencé sur l'unité formant canal d'écoulement.

9. Tête de distribution de liquide selon la revendication 8, dans laquelle la pluralité de couches métalliques disposées (36) ne recouvre pas la pluralité de chambres de pression (110).

10. Procédé de fabrication d'un actionneur piézoélectrique selon l'une quelconque des revendications 1 à 7 comprenant les étapes de :
dépôt d'une première couche métallique (36) sur une surface d'une couche piézoélectrique (41) ;
durcissement d'une couche d'électrode (35) sur la surface de la première couche métallique (36) ; et
durcissement d'une borne métallique (38) sur la couche d'électrode (35) de manière qu'elle soit raccordée électriquement à la couche d'électrode ; et durcissement d'une seconde couche métallique (37) sur la couche d'électrode.

11. Procédé de fabrication de l'actionneur piézoélectrique selon la revendication 10, dans lequel le durcissement de la borne métallique (38) comporte le durcissement de la borne métallique (38) de manière à ce qu'elle soit contenue dans la première couche métallique (36) lorsqu'elle est vue suivant la direction orthogonale à la surface de la couche piézoélectrique (41).

12. Procédé de fabrication d'un actionneur piézoélectrique selon la revendication 11, dans lequel le durcissement de la borne métallique (38) comporte le durcissement de la borne métallique (38) de manière à ce qu'elle soit contenue dans la couche d'électrode (35) lorsqu'elle est vue suivant la direction orthogonale à la surface de la couche piézoélectrique (41).

13. Procédé fabrication d'un actionneur piézoélectrique selon la revendication 12,
dans lequel l'étape de durcissement de la borne métallique (38) sur la couche d'électrode (35) comporte le durcissement de la borne métallique (38) sur la seconde couche métallique(37),
dans lequel le durcissement de la borne métallique (38) comporte le durcissement de la borne métallique (38) de manière à être contenue dans la seconde couche métallique lorsqu'elle est vue suivant la direction orthogonale à la surface de la surface piézoélectrique, et
dans lequel le durcissement de la seconde couche métallique comporte le durcissement de la seconde couche métallique de manière à ce qu'elle soit contenue dans la première couche métallique (38) lorsqu'elle est vue suivant la direction orthogonale à la surface de la couche piézoélectrique (41).

14. Procédé de fabrication d'une tête de distribution de liquide comprenant une unité formant canal d'écoulement comprenant les étapes de :
formation d'un actionneur piézoélectrique (21) selon la revendication 10 ; et
agencement en couche de l'actionneur piézoélectrique (21) sur une surface d'une unité formant canal d'écoulement (9), de telle sorte que la couche d'électrode (35) recouvre une chambre de pression (110) et la borne métallique (38) recouvre une partie de l'unité formant canal d'écoulement (9) autre que la chambre de pression (110).
